# EUROPÄISCHE PATENTANMELDUNG

(11) **EP 4 614 558 A1**
(43) Veröffentlichungstag der Anmeldung: **10.09.2025**
(21) Anmeldenummer: 24161706.7
(22) Anmeldetag: 06.03.2024
(51) Int. Cl.: H01L 23/049, H01L 23/10, H01L 23/36, H01L 23/498, H01L 25/07, H01L 23/00

(54) **GEHÄUSETEIL FÜR EIN HALBLEITERMODUL**

(71) Anmelder: Siemens Aktiengesellschaft, 80333 München (DE)
(72) Erfinder: Kürten, Bernd, 90587 Obermichelbach (DE)
(74) Vertreter: Siemens Patent Attorneys

(57) **Zusammenfassung**

Die Erfindung betrifft ein Gehäuseteil (2) für ein Halbleitermodul (22). Um eine zuverlässige Verdrahtung zu ermöglichen, wird vorgeschlagen, dass das Gehäuseteil (2) folgende Komponenten umfasst: einen Gehäuserahmen (4), welcher eine Auflagefläche (8) und eine in einem Winkel (φ) zur Auflagefläche (8) verlaufende Führungsnut (10) aufweist, einen in der Führungsnut (10) eingeschobenen Pin (6), welcher einen Fuß (12) und einen im Winkel (φ) zum Fuß (12) verlaufenden Schaft (14) aufweist, wobei der Schaft (14) des Pins (6) formschlüssig in der Führungsnut (10) des Gehäuserahmens (4) gehalten ist, und eine Dämpfungsschicht (20), über welche der Fuß (12) des Pins (6) stoffschlüssig mit der Auflagefläche (8) des Gehäuserahmens (4) verbunden ist.

## Beschreibung

Die Erfindung betrifft ein Gehäuseteil für ein Halbleitermodul.

Ferner betrifft die Erfindung ein Halbleitermodul mit mindestens einem derartigen Gehäuseteil.

Weiterhin betrifft die Erfindung einen Stromrichter mit mindestens einem derartigen Halbleitermodul.

Darüber hinaus betrifft die Erfindung ein Verfahren zur Herstellung eines Halbleitermoduls.

Eine derartiges Gehäuseteil kann unter anderem Teil eines Gehäuses für ein Leistungshalbleitermodul sein, das in der Regel in einem Stromrichter zum Einsatz kommt. Unter einem Stromrichter ist beispielsweise ein Gleichrichter, ein Wechselrichter, ein Umrichter oder ein Gleichspannungswandler zu verstehen. In einem derartigen Leistungshalbleitermodul kommen elektronischen Schaltungen zum Einsatz, welche unter anderem Transistoren, z.B. Insulated-Gate-Bipolar-Transistoren (IGBTs), Dioden, Triacs oder Thyristoren umfassen können. Zur Kontaktierung der elektronischen Schaltungen des Leistungshalbleitermoduls sind üblicherweise aus dem Gehäuse nach außen geführte Kontakte, sogenannte Pins, vorgesehen. Die Pins können unter anderem durch Drahtbonden im Gehäuse mit der elektronischen Schaltung verbunden werden. Ein gängiges Verfahren ist beispielsweise das Ultraschall-Drahtbonden, bei welchem ein Bonddraht mit einer Bondfläche eines Pins durch Druck und Ultraschallschwingungen verschweißt wird. Durch den Bondprozess, insbesondere beim Ultraschall-Drahtbonden, können unerwünschte Schwingungen im Bereich der Bondflächen der Pins, beispielsweise durch Resonanzen, angeregt werden, so dass eine Schweißverbindung zwischen dem Bonddraht und der Bondfläche eines Pins nicht oder nicht mit der geforderten Qualität zustande kommt.

Eine Aufgabe der vorliegenden Erfindung ist es daher, ein Gehäuseteil für ein Halbleitermodul anzugeben, welche eine zuverlässige Verdrahtung ermöglicht.

Diese Aufgabe wird erfindungsgemäß gelöst durch ein Gehäuseteil für ein Halbleitermodul mit einem Gehäuserahmen, welcher eine Auflagefläche und eine in einem Winkel zur Auflagefläche verlaufende Führungsnut aufweist, einem in der Führungsnut eingeschobenen Pin, welcher einen Fuß und einen im Winkel zum Fuß verlaufenden Schaft aufweist, wobei der Schaft des Pins formschlüssig in der Führungsnut des Gehäuserahmens gehalten ist, und einer Dämpfungsschicht, über welche der Fuß des Pins stoffschlüssig mit der Auflagefläche des Gehäuserahmens verbunden ist.

Ferner wird die Aufgabe erfindungsgemäß gelöst durch ein Halbleitermodul mit mindestens einem derartigen Gehäuseteil, wobei der Gehäuserahmen, insbesondere stoffschlüssig mit einer Wärmesenke verbunden ist, wobei auf der Wärmesenke eine elektronische Schaltung angeordnet ist, welche von dem Gehäuserahmen, insbesondere vollständig umschlossen ist, wobei der Fuß des Pins auf einer der Dämpfungsschicht abgewandten Seite eine Kontaktfläche aufweist und wobei die Kontaktfläche über ein Verdrahtungselement mit der elektronischen Schaltung verbunden ist.

Überdies wird die Aufgabe erfindungsgemäß gelöst durch einen Stromrichter mit mindestens einem derartigen Halbleitermodul.

Darüber hinaus wird die Aufgabe erfindungsgemäß durch ein Verfahren zur Herstellung eines Halbleitermoduls umfassend folgende Schritte: Bereitstellen eines Gehäuserahmens, welcher eine Auflagefläche und eine in einem Winkel zur Auflagefläche verlaufende Führungsnut aufweist, und eines Pins, welcher einen Fuß und einen im Winkel zum Fuß verlaufenden Schaft aufweist, Aufbringen eines adhäsiven elastischen Werkstoffs auf die Auflagefläche des Gehäuserahmens, Einschieben des Pins in die Führungsnut, wobei der Schaft des Pins formschlüssig in der Führungsnut des Gehäuserahmens gehalten und der Fuß des Pins über den adhäsiven elastischen Werkstoff stoffschlüssig mit der Auflagefläche des Gehäuserahmens verbunden wird, Aushärten des adhäsiven elastischen Werkstoffs zur Ausbildung einer Dämpfungsschicht, über welche der Fuß des Pins stoffschlüssig mit der Auflagefläche des Gehäuserahmens verbunden wird.

Die in Bezug auf das Gehäuseteil nachstehend angeführten Vorteile und bevorzugten Ausgestaltungen lassen sich sinngemäß auf das Halbleitermodul, den Stromrichter und das Herstellungsverfahren übertragen.

Der Erfindung liegt die Überlegung zugrunde, eine zuverlässige Verdrahtung eines Gehäuseteils für ein Halbleitermodul durch Dämpfung von während eines Verdrahtungsprozesses auftretende Schwingungen mittels einer Dämpfungsschicht zu ermöglichen. Als Verdrahtungselemente kommen unter anderem Bonddrähte oder Bondbänder infrage. Derartige Schwingungen treten in einem Gehäuseteil bei der Kontaktierung eines Pins, welcher in einem Gehäuserahmen des Gehäuseteils angeordnet ist, durch einen Bonddraht oder ein Bondband, welches durch Ultraschall-Drahtbonden verschweißt wird, auf. Der Pin ist beispielsweise aus einem metallischen Werkstoff, insbesondere durch Stanzen und anschließendes Biegen, hergestellt. Ein derartiger Pin, welcher einen Fuß und einen in einem Winkel, der beispielsweise bei 90° liegt, zum Fuß verlaufenden Schaft aufweist in eine Führungsnut des Gehäuserahmens eingeschoben, wobei der Gehäuserahmen eine Auflagefläche und die in einem Winkel, der beispielsweise dem Winkel des Pins entspricht, zur Auflagefläche verlaufende Führungsnut aufweist. Der Gehäuserahmen wird insbesondere aus einem Hochtemperatur-Kunstsoff hergestellt. Ein derartiger Hochtemperatur-Kunstsoff kann einen Schmelzpunkt über 240°C aufweisen. Hierbei kommt z.B. PPS (Polyphenylensulfid) infrage. Der Kunststoff kann mit einem anorganischen Werkstoff, der insbesondere Glas oder Keramik enthält, gefüllt sein. Die z.B. beim Ultraschall-Drahtbonden auftretenden Schwingungen sind bei einem derartigen Hochtemperatur-Kunstsoff besonders stark ausgeprägt.

Der Fuß des Pins wird über einen adhäsiven elastischen Werkstoff mit der Auflagefläche des Gehäuserahmens verbunden. Der adhäsive elastische Werkstoff kann unter anderem in Form einer, insbesondere durchgängigen, Raupe, insbesondere Kleberaupe, aufgetragen werden. Nach einem Aushärtevorgang des adhäsiven elastischen Werkstoffs bildet dieser die Dämpfungsschicht zur Dämpfung der Schwingungen aus. Ferner wird der Fuß des Pins über die Dämpfungsschicht stoffschlüssig mit der Auflagefläche des Gehäuserahmens verbunden. Der Schaft des Pins wird dabei formschlüssig in der Führungsnut des Gehäuserahmens gehalten. Im Gegensatz zum Vergießen des Pins hat dieser noch in Richtung der Führungsnut Spiel. Zusammen mit der Dämpfung der Schwingungen durch die Dämpfungsschicht ist eine zuverlässige und langlebige Drahtverbindung zum Pin ausbildbar.

Eine weitere Ausführungsform sieht vor, dass die Dämpfungsschicht einen elastischen Klebstoff, insbesondere einen Silikonkleber, enthält. Ein elastischer, insbesondere dauerelastischer, Klebstoff kann beispielsweise ein Elastomer sein. Derartige Schichten sind nicht nur zuverlässig, sondern auch günstig herstellbar. Der Werkstoff zum Herstellender Dämpfungsschicht bzw. seine Zusammensetzung wird insbesondere so ausgewählt, dass dieser eine für die zum Schweißen eingesetzte Ultraschallfrequenz eine möglichst hohe Dämpfung aufweist.

Eine weitere Ausführungsform sieht vor, dass die Führungsnut als Hammerkopfnut oder Schwalbenschwanznut ausgeführt ist. Derartige Nuten sind langlebig und günstig, beispielsweise mittels eines Spritzgussverfahrens, herstellbar.

Eine weitere Ausführungsform sieht vor, dass der Fuß des Pins vollflächig mit der Dämpfungsschicht verbunden ist. Durch eine derartige vollflächige Verbindung mit der Dämpfungsschicht findet eine besonders gute Schwingungsdämpfung statt, sodass eine verbesserte Zuverlässigkeit erreicht wird.

Eine weitere Ausführungsform sieht vor, dass die Dämpfungsschicht punktuell, insbesondere unmittelbar unter dem Fuß des Pins, aufgebracht ist. Insbesondere wird der adhäsive elastische Werkstoff zur Ausbildung der Dämpfungsschicht punktförmig appliziert. Somit ist die Dämpfungsschicht nach dem Bestücken der Pins bedeckt und vor Verunreinigungen, z.B. Fasern, geschützt.

Eine weitere Ausführungsform sieht vor, dass sich mindestens 90 %, insbesondere mindestens 95 %, der Oberfläche der Dämpfungsschicht unter dem Fuß des Pins befinden. Somit wird Klebstoff eingespart und es werden Verunreinigungen besonders effizient vermieden.

Eine weitere Ausführungsform sieht vor, dass das Gehäuseteil mindestens zwei Pins aufweist, welche jeweils in einer Führungsnut eingeschobenen und über eine separate Dämpfungsschicht mit der Auflagefläche des Gehäuserahmens verbunden sind. Beispielsweise sind mindestens zwei Pins benachbart bzw. nebeneinander angeordnet, ohne dass sich deren Dämpfungsschichten gegenseitig zu berühren. Auf diese Weise findet bei jedem Verdrahtungsvorgang eine optimale Schwingungsunterdrückung statt.

Eine weitere Ausführungsform sieht vor, dass der Schaft des Pins ein beidseitig angeordnetes Befestigungsprofil, welches zum formschlüssigen Halten des Pins in der Führungsnut konfiguriert ist, aufweist. Das Befestigungsprofil kann unter anderem zumindest eine beidseitige, insbesondere symmetrisch angeordnete, fähnchenartige Verbreiterung des Schaftes beinhalten. Insbesondere ist der Pin achsensymmetrisch ausgeführt. Durch ein derartiges Befestigungsprofil wird der Pin aufrecht in der Führungsnut gehalten.

Eine weitere Ausführungsform sieht vor, dass die Führungsnut im Wesentlichen senkrecht zur Auflagefläche und der Schaft im Wesentlichen senkrecht zum Fuß des Pins verlaufend angeordnet ist. Eine derartige Anordnung ermöglicht bei einer externen Kontaktierung des Schafts des Pins eine optimierte Kraftübertragung bei minimaler Belastung der Dämpfungsschicht und ermöglicht so eine hohe Lebensdauer der Anordnung.

Im Folgenden wird die Erfindung anhand der in den Figuren dargestellten Ausführungsbeispiele näher beschrieben und erläutert.

Es zeigen:
- FIG 1: schematisches Ablaufdiagramm eines Verfahrens zur Herstellung eines Gehäuseteils für ein Halbleitermodul,
- FIG 2: eine schematische dreidimensionale Darstellung eines Pins,
- FIG 3: eine schematische Längsschnitt-Darstellung eines Halbleitermoduls mit einem Gehäuseteil,
- FIG 4: eine schematische Querschnitt-Darstellung eines Ausschnitts des Halbleitermoduls im Bereich eines Pins,
- FIG 5: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

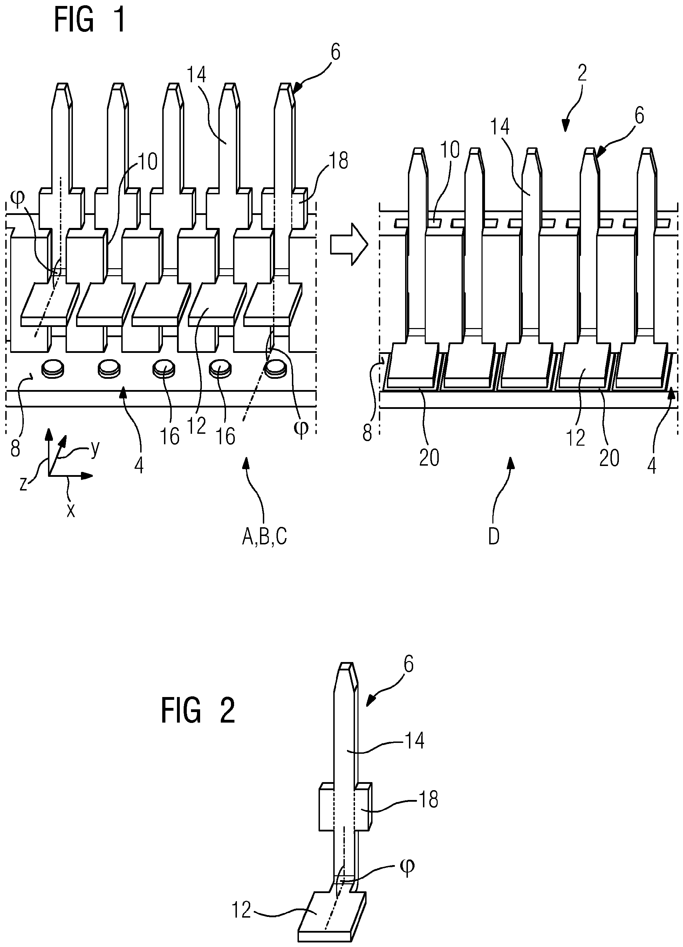

FIG 1 zeigt ein schematisches Ablaufdiagramm eines Verfahrens zur Herstellung eines Gehäuseteils 2 für ein Halbleitermodul. Das Verfahren umfasst ein Bereitstellen A eines Gehäuserahmens 4 und eines Pins 6. Der Gehäuserahmen 4 ist aus einem Kunststoff, insbesondere einem Hochtemperatur-Kunstsoff. hergestellt. Ein derartiger Hochtemperatur-Kunstsoff kann einen Schmelzpunkt über 240°C aufweisen. Hierbei kommt z.B. PPS (Polyphenylensulfid) infrage. Der Kunststoff kann mit einem weiteren Werkstoff, insbesondere einem anorganischen Werkstoff, welcher z.B. ein Glas oder eine Keramik enthält, gefüllt sein. Der Gehäuserahmen 4 weist eine Auflagefläche 8 und unter einem Winkel φ zur Auflagefläche 8 verlaufende Führungsnuten 10, welche beispielhaft als Hammerkopfnuten ausgeführt sind, auf. Durch die Auflagefläche 8 wird eine xy-Ebene definiert, wobei die Führungsnuten 10 senkrecht zur xy-Ebene in z-Richtung verlaufend angeordnet sind. Die Pins 6 weisen jeweils einen Fuß 12 und einen im Wesentlichen senkrecht zum Fuß 12 verlaufenden Schaft 14 auf. Die Pins 6 sind aus einem metallischen Werkstoff, beispielsweise durch Stanzen und anschließendes Biegen, hergestellt. Ferner umfasst das Verfahren ein Aufbringen B eines adhäsiven elastischen Werkstoffs 16 auf die Auflagefläche 8 des Gehäuserahmens 4. Der adhäsive elastische Werkstoff 16 enthält beispielsweise einen elastischen, insbesondere dauerelastischen, Klebstoff wie einen Silikonkleber. Überdies umfasst das Verfahren ein Einschieben C jeweils eines Pins 6 in eine der Führungsnuten 10, wobei beim Einschieben C der Fuß 12 des Pins 6 über den adhäsiven elastischen Werkstoff 16 mit der Auflagefläche 8 des Gehäuserahmens 4 verbunden wird. Der adhäsive elastische Werkstoffs 16 ist zur stoffschlüssigen Verbindung des Pins 6 mit der Auflagefläche 8 vorgesehen. Der adhäsive elastische Werkstoffs 16 wird punktförmig unmittelbar unter dem Fuß 12 des jeweiligen Pins 6 appliziert. Die Schäfte 14 der Pins 6 weisen jeweils ein beidseitig angeordnetes Befestigungsprofil 18 auf. Das Befestigungsprofil 18 ist korrespondierend zur Führungsnut 10 ausgeführt, wobei die Pins 6 nach dem Einschieben C über die Befestigungsprofile 18 formschlüssig in x- und y-Richtung in der jeweiligen Führungsnut 10 gehalten werden. Beispielhaft ist das Befestigungsprofil 18 als symmetrische fähnchenartige Verbreiterung des Schaftes 14 ausgeführt.

Darüber hinaus umfasst das Verfahren ein Aushärten D des adhäsiven elastischen Werkstoffs 16 zur Ausbildung einer Dämpfungsschicht 20, über welche der Fuß 12 des Pins 6 stoffschlüssig mit der Auflagefläche 8 des Gehäuserahmens 4 verbunden wird. Das Aushärten D erfolgt thermisch, beispielsweise mittels Infrarotstrahlung oder Induktion. Beim Einschieben C der Pins 6 wird der jeweilige Fuß 12 derartig auf den punktförmig unmittelbar unter dem Fuß 12 des jeweiligen Pins 6 applizierten adhäsiven elastischen Werkstoff 16 gedrückt, dass sich nach dem Aushärten D mindestens 90 %, insbesondere mindestens 95 %, der Oberfläche der Dämpfungsschicht 20 unter dem Fuß 12 des Pins 6 befinden und sich die Dämpfungsschichten 20 der Pins 6 nicht gegenseitig berühren. Um eine derartige Abdeckung zu erreichen, kann im Bereich der Oberfläche der Dämpfungsschicht 20 in Auflagefläche 8 eine, insbesondere umlaufende, Nut eingebracht sein, welcher zur Aufnahme eines überschüssigen adhäsiven elastischen Werkstoffs 16 dient. Zusätzlich oder alternativ kann eine derartige Nut in eine der Auflagefläche 8 zugewandte Fläche des Fußes 12 des Pins 6 eingebracht sein.

Auf diese Weise wird unter jedem der Pins 6 eine separate Dämpfungsschicht 20 ausgebildet, welche die Pins 6 stoffschlüssig mit der Auflagefläche 8 verbindet. Ferner ist die noch nicht vollständig ausgehärtete Dämpfungsschicht 20 nach dem Bestücken der Pins 6 abgedeckt und vor Verunreinigungen, z.B. durch Fasern, geschützt. Durch das Anordnen des Pins 6 in der Führungsnut 10 hat der Pin 6 in z-Richtung, abhängig von der Dämpfungsschicht 20 ein gewisses Spiel.

FIG 2 zeigt eine schematische dreidimensionale Darstellung eines Pins 6, welcher achsensymmetrisch ausgeführt ist und der Ausführung in FIG 1 entspricht.

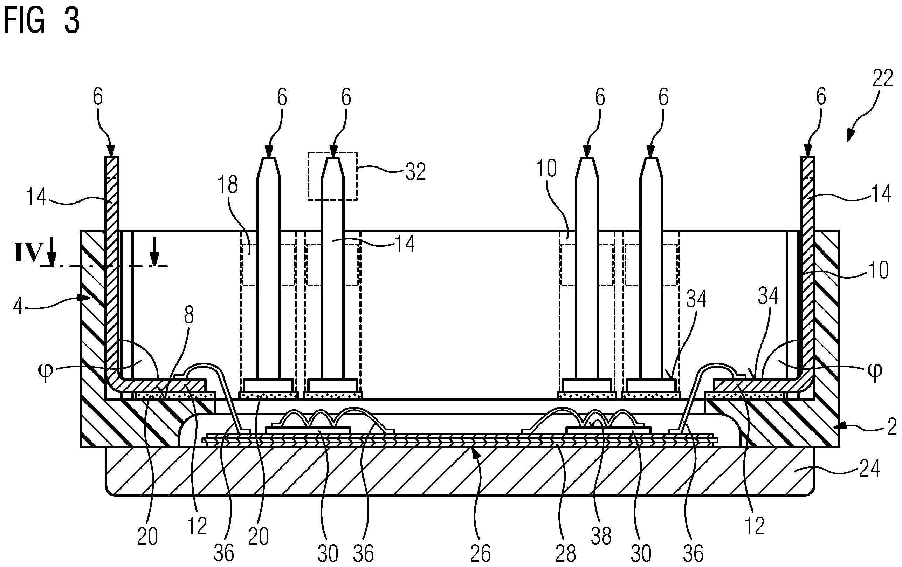

FIG 3 zeigt eine schematische Schnittdarstellung eines Halbleitermoduls 22 mit einem Gehäuseteil 2, welcher wie in FIG 1 gezeigt hergestellt ist. Der Gehäuserahmen 4 ist stoffschlüssig, z.B. durch Kleben, mit einer Wärmesenke 24 verbunden, welche als beispielhaft als metallische Bodenplatte ausgeführt ist. Die Wärmesenke 24 kann alternativ unter anderem als Kühlkörper ausgeführt sein. Auf der Bodenplatte ist eine elektronische Schaltung 26 angeordnet, welche von dem Gehäuserahmen 4 vollständig umschlossen ist. Die elektronische Schaltung 26 umfasst ein Substrat 28, auf welchem Halbleiterelemente 30 stoffschlüssig verbunden sind, wobei das Substrat 28 auf einer den Halbleiterelementen 30 abgewandten Seite mit der metallischen Bodenplatte verbunden. Das Substrat 28 umfasst eine beidseitig metallisierte dielektrische Materiallage, die einen keramischen Werkstoff, beispielsweise Aluminiumnitrid oder Aluminiumoxid, oder einen organischen Werkstoff, beispielsweise einem Polyamid enthält. Die dielektrische Materiallage kann eine Dicke von 25 µm bis 600 µm, insbesondere 50 µm bis 320 µm, aufweisen. Die Halbleiterelemente 30 können zumindest einen, insbesondere vertikalen, Transistor, insbesondere einen Insulated-Gate-Bipolar-Transistor (IGBT), umfassen. Ferner kann zumindest einem Transistor eine, insbesondere antiparallel geschaltete, Diode zugewiesen sein. Die stoffschlüssige Verbindung der Halbleiterelemente 30 mit dem Substrat 28 ist unter anderem durch Löten und/oder Sintern herstellbar.

Insbesondere sind die Pins 6 im Wesentlichen identisch ausgeführt. Ein Kontaktierungsbereich 32 des Schaftes 14 der Pins 6 ist zur Herstellung einer Verbindung, z.B. Lötverbindung oder Pressfit-Verbindung, mit einer Leiterplatte, konfiguriert. Die Füße 12 der Pins 6 weisen jeweils eine Kontaktierungsfläche 34 auf, welche beispielhaft als eine Bondfläche ausgeführt ist. Die Kontaktierungsfläche 34 ist zur Herstellung einer elektrischen Verbindung zwischen dem Pin 6 und zumindest einem der Halbleiterelemente 30 konfiguriert, wobei die elektrische Verbindung unmittelbar auf das Halbleiterelement 30 oder über das Substrat 28 erfolgen kann. Zur elektrischen Verbindung werden Verdrahtungselemente 36 herangezogen, welche in FIG 3 von der Kontaktierungsfläche 34 des jeweiligen Pins 6 ausgehend mit dem Substrat 28 verbunden werden. Weitere Verdrahtungselemente 36 werden mit Verdrahtungsflächen 38 der Halbleiterelemente 30 verbunden. Die Verdrahtungselemente 36 können unter anderem als Bonddrähte oder Bondbänder ausgeführt sein, welche in einem Ultraschall-Drahtbond-Verfahren mit der jeweiligen Oberfläche verschweißt werden. Bei der Herstellung einer derartigen Bondverbindung auftretende Schwingungen werden zumindest teilweise durch die zwischen dem Fuß 12 des Pins 6 und der Auflagefläche 8 des Gehäuserahmens 4 angeordnete Dämpfungsschicht 20 gedämpft. Die weitere Ausführung des Gehäuseteils 2 in FIG 3 entspricht der in FIG 1.

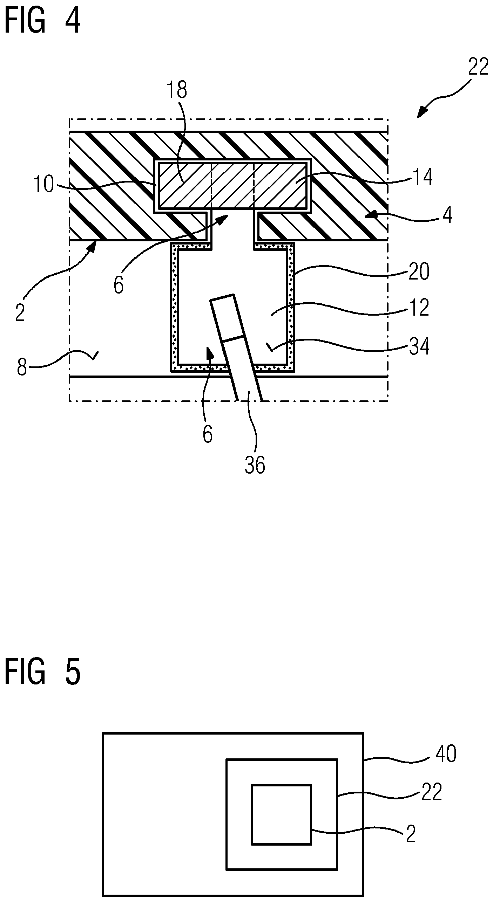

FIG 4 zeigt eine schematische Querschnitt-Darstellung eines Ausschnitts des Halbleitermoduls 22 im Bereich eines Pins 6. Die Ausführung des Halbleitermoduls 22 entspricht der in FIG 3.

FIG 5 zeigt eine schematische Darstellung eines Stromrichters 40, welcher ein Halbleitermodul 22, das eine Gehäuseteil 2 aufweist, umfasst. Der Stromrichter 40 kann mehr als ein Halbleitermodul 22 umfassen.

Zusammenfassend betrifft die Erfindung ein Gehäuseteil 2 für ein Halbleitermodul 22. Um eine zuverlässige Verdrahtung zu ermöglichen, wird vorgeschlagen, dass das Gehäuseteil 2 folgende Komponenten umfasst: einen Gehäuserahmen 4, welcher eine Auflagefläche 8 und eine in einem Winkel φ zur Auflagefläche 8 verlaufende Führungsnut 10 aufweist, einen in der Führungsnut 10 eingeschobenen Pin 6, welcher einen Fuß 12 und einen im Winkel φ zum Fuß 12 verlaufenden Schaft 14 aufweist, wobei der Schaft 14 des Pins 6 formschlüssig in der Führungsnut 10 des Gehäuserahmens 4 gehalten ist, und eine Dämpfungsschicht 20, über welche der Fuß 12 des Pins 6 stoffschlüssig mit der Auflagefläche 8 des Gehäuserahmens 4 verbunden ist.

## Patentansprüche

1. Gehäuseteil (2) für ein Halbleitermodul (22) mit
- einem Gehäuserahmen (4), welcher eine Auflagefläche (8) und eine in einem Winkel (φ) zur Auflagefläche (8) verlaufende Führungsnut (10) aufweist,
- einem in der Führungsnut (10) eingeschobenen Pin (6), welcher einen Fuß (12) und einen im Winkel (φ) zum Fuß (12) verlaufenden Schaft (14) aufweist,
wobei der Schaft (14) des Pins (6) formschlüssig in der Führungsnut (10) des Gehäuserahmens (4) gehalten ist, und
- einer Dämpfungsschicht (20), über welche der Fuß (12) des Pins (6) stoffschlüssig mit der Auflagefläche (8) des Gehäuserahmens (4) verbunden ist.

2. Gehäuseteil (2) nach Anspruch 1,
wobei die Dämpfungsschicht (20) einen elastischen Klebstoff, insbesondere einen Silikonkleber, enthält.

3. Gehäuseteil (2) nach einem der Ansprüche 1 oder 2,
wobei die Führungsnut (10) als Hammerkopfnut oder Schwalbenschwanznut ausgeführt ist.

4. Gehäuseteil (2) nach einem der vorherigen Ansprüche,
wobei der Fuß (12) des Pins (6) vollflächig mit der Dämpfungsschicht (20) verbunden ist.

5. Gehäuseteil (2) nach einem der vorherigen Ansprüche,
wobei die Dämpfungsschicht (20) punktuell, insbesondere unmittelbar unter dem Fuß (12) des Pins (6), aufgebracht ist.

6. Gehäuseteil (2) nach Anspruch 5,
wobei sich mindestens 90 %, insbesondere mindestens 95 %, der Oberfläche der Dämpfungsschicht (20) unter dem Fuß (12) des Pins (6) befinden.

7. Gehäuseteil (2) nach einem der vorherigen Ansprüche,
aufweisend mindestens zwei Pins (6), welche jeweils in einer Führungsnut (10) eingeschobenen und über eine separate Dämpfungsschicht (20) mit der Auflagefläche (8) des Gehäuserahmens (4) verbunden sind.

8. Gehäuseteil (2) nach einem der vorherigen Ansprüche,
wobei der Schaft (14) des Pins (6) ein beidseitig angeordnetes Befestigungsprofil (18), welches zum formschlüssigen Halten des Pins (6) in der Führungsnut (10) konfiguriert ist, aufweist.

9. Gehäuseteil (2) nach einem der vorherigen Ansprüche,
wobei die Führungsnut (10) im Wesentlichen senkrecht zur Auflagefläche (8) und
der Schaft (14) im Wesentlichen senkrecht zum Fuß (12) des Pins (6) verlaufend angeordnet ist.

10. Halbleitermodul (22) mit mindestens einem Gehäuseteil (2) nach einem der vorherigen Ansprüche,
wobei der Gehäuserahmen (4), insbesondere stoffschlüssig mit einer Wärmesenke (24) verbunden ist,
wobei auf der Wärmesenke (24) eine elektronische Schaltung (26) angeordnet ist, welche von dem Gehäuserahmen (4), insbesondere vollständig umschlossen ist,
wobei der Fuß (12) des Pins (6) auf einer der Dämpfungsschicht (20) abgewandten Seite eine Kontaktierungsfläche (34) aufweist und wobei die Kontaktierungsfläche (34) über ein Verdrahtungselement (36) mit der elektronischen Schaltung (26) verbunden ist.

11. Stromrichter (40) mit mindestens einem Halbleitermodul (22) nach Anspruch 10.

12. Verfahren zur Herstellung eines Halbleitermoduls (22) umfassend folgende Schritte:
- Bereitstellen (A) eines Gehäuserahmens (4), welcher eine Auflagefläche (8) und eine in einem Winkel (φ) zur Auflagefläche (8) verlaufende Führungsnut (10) aufweist, und
eines Pins (6), welcher einen Fuß (12) und einen im Winkel (φ) zum Fuß (12) verlaufenden Schaft (14) aufweist,
- Aufbringen (B) eines adhäsiven elastischen Werkstoffs (16) auf die Auflagefläche (8) des Gehäuserahmens (4),
- Einschieben (C) des Pins (6) in die Führungsnut (10),
wobei der Schaft (14) des Pins (6) formschlüssig in der Führungsnut (10) des Gehäuserahmens (4) gehalten und
der Fuß (12) des Pins (6) über den adhäsiven elastischen Werkstoff (16) mit der Auflagefläche (8) des Gehäuserahmens (4) verbunden wird,
- Aushärten (D) des adhäsiven elastischen Werkstoffs (16) zur Ausbildung einer Dämpfungsschicht (20), über welche der Fuß (12) des Pins (6) stoffschlüssig mit der Auflagefläche (8) des Gehäuserahmens (4) verbunden wird.

13. Verfahren nach Anspruch 12,
wobei der Fuß (12) des Pins (6) vollflächig mit dem adhäsiven elastischen Werkstoff (16) verbunden wird.

14. Verfahren nach einem der Ansprüche 12 oder 13,
wobei das Aufbringen (B) des adhäsiven elastischen Werkstoffs (16) punktuell, insbesondere unmittelbar unter dem Fuß (12) des Pins (6), erfolgt.

15. Verfahren nach Anspruch 14,
wobei beim Einschieben (C) des Pins (6) dessen Fuß (12) derartig auf den adhäsiven elastischen Werkstoff (16) gedrückt wird, dass sich nach dem Aushärten (D) mindestens 90 %, insbesondere mindestens 95 %, der Oberfläche der Dämpfungsschicht (20) unter dem Fuß (12) des Pins (6) befinden.

16. Verfahren nach Anspruch 15,
wobei im Bereich der Oberfläche der Dämpfungsschicht (20) in die Auflagefläche (8) und/oder in eine der Auflagefläche (8) zugewandte Fläche des Fußes (12) des Pins (6) eine, insbesondere umlaufende, Nut eingebracht wird, welcher zur Aufnahme eines überschüssigen adhäsiven elastischen Werkstoffs (16) konfiguriert ist.

17. Verfahren nach einem der Ansprüche 12 bis 16,
wobei das Aushärten (D) thermisch, insbesondere mittels Infrarotstrahlung und/oder Induktion, erfolgt.

18. Verfahren nach einem der Ansprüche 12 bis 17,
wobei der Gehäuserahmen (4), insbesondere stoffschlüssig mit einer Wärmesenke (24) verbunden wird,
wobei auf der Wärmesenke (24) eine elektronische Schaltung (26) angeordnet wird, welche von dem Gehäuserahmen (4), insbesondere vollständig umschlossen wird,
wobei der Fuß (12) des Pins (6) auf einer der Dämpfungsschicht (20) abgewandten Seite eine Kontaktierungsfläche (34) aufweist und wobei die Kontaktierungsfläche (34) über ein Verdrahtungselement (36) mit der elektronischen Schaltung (26) verbunden wird.
